Europäisches Patentamt

European Patent Office

Office européen des brevets

(11) Publication number: **0 188 052 B1**

## (12) EUROPEAN PATENT SPECIFICATION

(45) Date of publication of patent specification: **15.05.91** (51) Int. Cl.⁵: **G01R 33/28**, G06F 15/20

(21) Application number: **85304887.4**

(22) Date of filing: **09.07.85**

(54) **A multiple FIFO NMR acquisition system.**

(30) Priority: **16.01.85 US 691783**

(43) Date of publication of application:
**23.07.86 Bulletin 86/30**

(45) Publication of the grant of the patent:
**15.05.91 Bulletin 91/20**

(84) Designated Contracting States:
**AT BE CH DE FR GB IT LI LU NL SE**

(56) References cited:
**WO-A-81/01881**
**GB-A- 2 021 780**
**US-A- 4 063 310**
**US-A- 4 176 400**

(73) Proprietor: **VARIAN ASSOCIATES, INC.**
**611 Hansen Way**
**Palo Alto, CA 94303(US)**

(72) Inventor: **Codrington, Robert Smith**
**26815 St. Francis Drive**
**Los Altos Hills California(US)**

(74) Representative: **Cline, Roger Ledlie et al**
**EDWARD EVANS & CO. Chancery House**
**53-64 Chancery Lane**
**London WC2A 1SD(GB)**

## Description

This invention is in the field of instrumentation for cyclic instrument control and data acquisition and particularly relates to time domain data acquisition systems for NMR and related measurements.

In the prior art it was known to incorporate within NMR data control systems a FIFO containing a sequence of codes defining the respective sequence of operative states of the apparatus, each together with a persistence datum encoding a corresponding time interval during which each state is maintained. The imminent underflow of the FIFO caused an interrupt to a host processor which responded to reinitialize the FIFO. The sequence was therefore executed in precise synchronism. Such a system is described in US-A 4,191,919.

Further, the FIFO based systems of the prior art address system requirements for enhanced information density by implementing re-entrant operation of the FIFO to reduce interrupt overhead. In this manner an entire set of periodically repetitive operations contained in a re-entrant FIFO structure could be rotated through an output register for a desired number of cycles (of the sequence) to control the spectrometer accordingly and re-inserted in the FIFO to maintain the queue. Another prior art feature permitted compressed repetitive instructions by defining a repetition field of the FIFO word for the purpose of specifying the number of times that a particular state and persistence interval are to be repeated. The purpose of such FIFO based system enhancement is to effectively increase the effective FIFO capacity in the number of control words asserted without interrupt of the host processor. A reentrant FIFO based system also incorporating a repetition feature is described in U.S. Patent No. 4,375,676.

These prior art FIFO based systems are well adapted to many repetitions of a sequence of words not exceeding the maximum FIFO capacity in length, or to a large number of repetitions of a particular control word. These techniques are not well adapted to the execution of compact macros of instructions which may be desired for execution within the periodic sequence or to very long (non-repetitive) sequences which exceed the FIFO capacity.

WO-A-8101881 discloses a data control system comprising a variable length FIFO register for receiving/propagating a list of data words from/to an input/output stage. In one aspect, the invention provides a method of processing a FIFO data list of variable length greater than a minimum number of words in which it reads to a processor of first FIFO data list of no more than a fixed number of words and differs from the reference in the characterising clause set out in Claim 1. In another aspect, the invention provides a variable length FIFO register for furnishing a sequence of digital words to an output register comprising first FIFO means as set out in the introductory portion of Claim 3 and differs from the cited specification by the components of the characterising clause of Claim 3.

An example of the invention will now be described with reference to the accompanying drawings in which:

FIG. 1 depicts the control environment of an NMR apparatus incorporating the invention.

FIG. 2 is a block diagram of the FIFO system of the present invention.

FIG. 3A shows an example word format for main sequence execution.

FIG. 3B shows an example word format for causing a subsequence call.

FIG. 3C shows an example word format subsequence execution.

FIG. 3D shows an example word format for causing a return to mainsequence execution.

FIG. 4 is a partial block diagram of different embodiments of the invention.

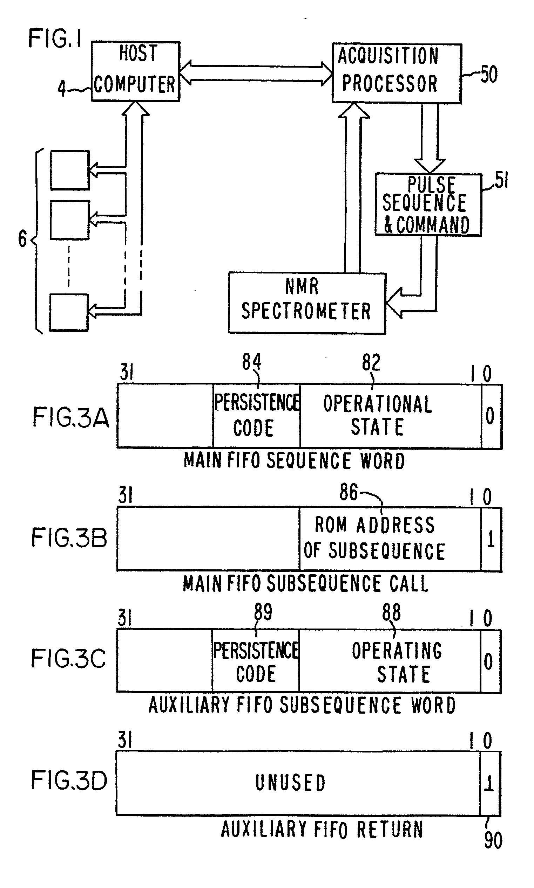

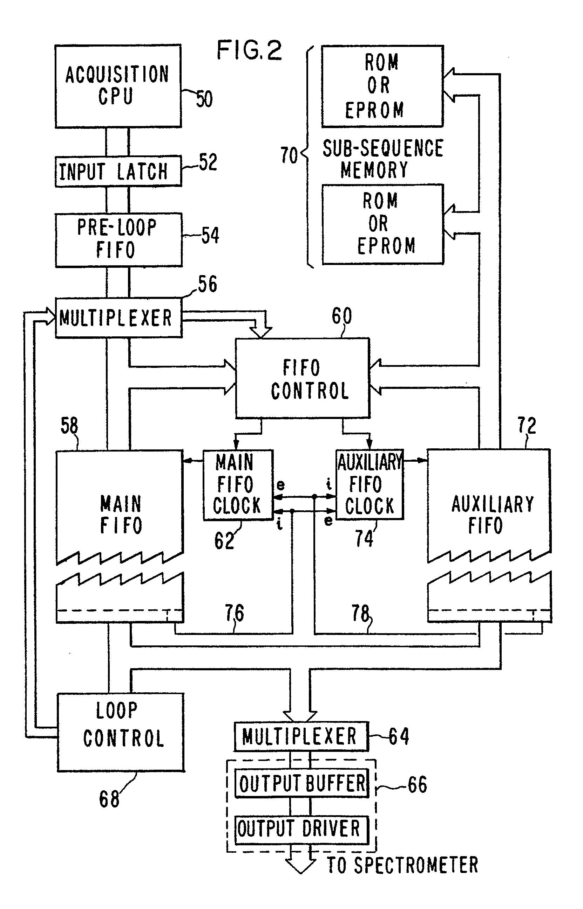

One instrumental context for the present invention is shown in FIG. 1. There, an NMR spectrometer system comprises the spectrometer 2, a host computer 4 in association with a number of I/O peripheral devices 6 and a spectrometer controller or acquisition processor 50 form a data acquisition system for NMR measurements. An integral part of the acquisition processor 50 is the pulse sequence controller 51, the major portion of which forms the subject of the present invention as further described below. The terms "pulse sequence controller" and "instrumental controller" will not be differentiated. The present invention may supply pulses of standard length at selected times, or levels of selected length at selected times with full generality which is not limited by the particular context of NMR measurements which is here given for a specific context.

FIG. 2 illustrates the architecture of an expanded FIFO based instrumental controller. Acquisition processor 50 communicates through latch 52 with pre-loop FIFO 54, thence through multiplexer 56 with the main FIFO 58 and FIFO controller 60. As in prior art discussed above, a portion of the word passed to the FIFO 58 through the aforementioned chain will initiate a spectrometer operating state or command executable by the spectrometer apparatus. Another portion of the word passed to the FIFO contains persistence information, e.g., the time interval during which the operative state of the spectrometer is to continue. Persistence interval is metered by the main FIFO clock 62 which is initialized from the persistence portion of the FIFO word.

The currently executable word is presented to the NMR apparatus through multiplexer 64 to output handler 66. Concurrently the same control word is redirected through loop control 68 to FIFO 58 through multiplexer 56, thereby preserving the FIFO queue. It is understood that ordinarily a cyclic sequence which does not exceed the length of the main FIFO will be initialized in the main FIFO 58 and during loop operation the multiplexer 56 will inhibit further inputs permitting only the circulation of FIFO control words through the loop control 68 to multiplexer 56.

Turning now to FIG. 3A, there is observed a FIFO control word format suitable for circulation through the main FIFO 58 for direct execution. The format comprises an operational state portion 82, a persistence interval code 84 and possibly other fields to be discussed below and as described in prior art. A flag bit, bit 0 in this instance, remains 0 to so identify the executable sequence word as such.

FIG. 3B shows the format for a sub-sequence call control word containing an address portion which is the address of an entry point of a desired sub-sequence residing in auxiliary memory. Bit 0 is the sub-sequence flag bit and is set to 1 to so distinguish the sub-sequence call. When this bit is encountered in multiplexer 56, FIFO control 60 causes a fetch loop to commence with the address at the indicated entry point in ROM 70. The sub-sequence following the entry point is loaded into auxiliary FIFO 72 until the end-of-sub-sequence control code (bit 0 = 1) is encountered in the sub-sequence. It is preferred to load this end code also, thereby preserving an end mark in the auxiliary FIFO 72, and providing an active code or flag bit for control purposes during execution.

Loading of the auxiliary FIFO 72 is carried out in conventional ripple-down mode at maximum rate under control of the auxiliary FIFO clock 74, or other high speed clock (not shown). It will be apparent that this operation may be executed by a parallel structure addressing ROM.

During FIFO execution, the presence of the sub-sequence flag in the main FIFO sequence is detected and utilized to inhibit the main FIFO clock 58 and concurrently enable the auxiliary FIFO clock 74 in the self synchronized mode wherein the clock interval is taken from the persistence code 89 of the auxiliary FIFO control word. The main FIFO output is also monitored to detect the presence of the sub-sequence call flag. This occurrence causes control to transfer to the auxiliary FIFO 72 and the content of the auxiliary FIFO 72 advances through multiplexer 64 toward the spectrometer interface. When the return flag 90 is encountered in the auxiliary FIFO 72 (Fig. 3D) control is passed back to the main FIFO which resumes its rotation of control word information through loop control 68 and again provides out through multiplexer 64. The exchange of control between the main and auxiliary FIFOs 58 and 72 is shown symbolically by signal 76 inhibiting main FIFO clock 62 and enabling auxiliary FIFO clock 74 and through signal 78 performing the complementary function. Although not shown in detail, it will be understood that the respective signals logically determine a status bit from which FIFO control 60 activates the indicated FIFO. The clocks 62 and 74 are derived from a common source to assure synchrony and may comprise gates for a single physical clock source to the respective FIFOs.

Limitations on the length of the sub-sequence depend ultimately upon the data rate available for accessing ROM 70 and initializing the auxiliary FIFO 72 and the capacity of the latter. That is, there is a limit imposed by the time available for initializing the sub-sequence in FIFO 72 which limit is the interval between detection of the sub-sequence call bit at multiplexer 56 and the presence of the word containing such call at the output of main FIFO 58. This time interval is calculable from the sum of persistence times for all preceding main FIFO content. It is, therefore, desirable for FIFO control 60 to be capable of accessing ROM 70 at the highest rate and for maximum ripple rate operation for initializing auxiliary FIFO 72. Thus, auxiliary FIFO clock 74 is capable of clocking the auxiliary FIFO at a very high rate for initialization as well as operating at a somewhat lower rate.

FIFO control 60 is preferably an intelligent controller and in a preferred form is a parallel structure permitting concurrency of its two principal functions: supervision of FIFO 58 operation and initialization of Auxiliary FIFO 72. These functions are distinct and need not be mutually synchronous, it only being required that auxiliary FIFO 72 be ready to produce its content synchronously with the appearance of a corresponding token at the output of FIFO 58. The actual operation of FIFO 72 is identical to that of FIFO 58 with respect to presentation of the sequence control word at multiplexer 64. The source of the control word is invisible to the output buffer 66.

An advantage of the present architecture may be seen in the simplification of an effective variable length FIFO system. For a single FIFO system of the prior art, variable sequence length must be accommodated by an arrangement for gating reentrant control words to the correct entrance stage of the single FIFO. The sequence length for reentrant operation is then limited by the length of the single FIFO in stages. In the present architecture it is appropriate for the main FIFO length to be modest and preferably equal to or somewhat less lengthy than the shorter sequences because it is precisely the incremental length of the sequence that is supplied by the auxiliary FIFO.

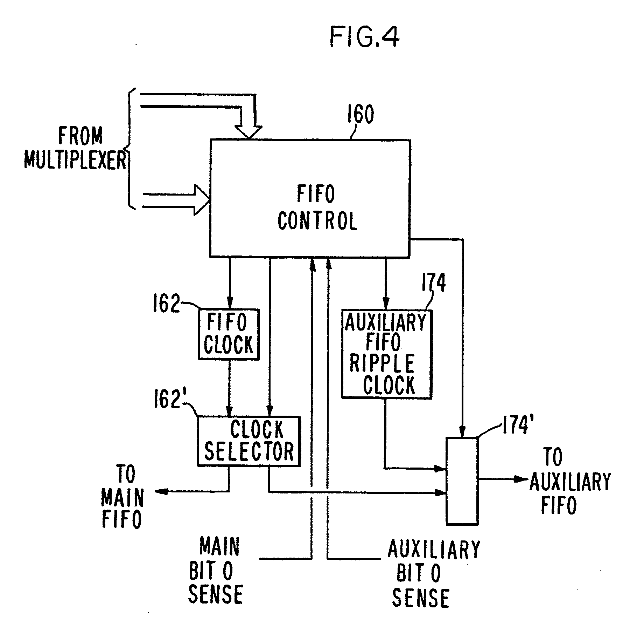

A slightly different embodiment shown in FIG. 4 employs a single FIFO clock 162 for clocking either the main or auxiliary FIFOs 158 and 172 through clock selecter 162'. The latter is responsive to logic in controller 160 for resolving the relative status of main and auxiliary FIFOs by monitoring bit 0 of the word currently active at the output of the respective FIFOs and for implementing special overrides such as power-up reset and like exceptional conditions. A special high speed clock 174 is selectable by controller 160 when a subsequence call is detected in the main sequence as previously discussed. This high speed clock serves the limited purpose of of rapid initialization of the auxiliary FIFO. In this manner the auxiliary FIFO is clocked in precisely the same manner as the main FIFO during subsequence execution operations, but the auxiliary FIFO may be run at a much higher rate for initialization purposes.

Certain rules and limitations will be apparent from the discussions above. Time limitations are inherent in the time available for initializing the auxiliary FIFO. This and the incidence of multiple subsequence calls in proximity (so as to limit the time for initialization of the auxiliary FIFO) and other conditions are preferably resolved in software which serves the purpose of compiling and allocating the desired operational state information prior to operations. Many of the special situations alluded to here may be remedied in a straightforward fashion. For example, the desired minimum time interval between subsequence calls can be gained by incorporating a portion of the content of the desired subsequence within the main sequence and then off-setting the entry point when the subsequence call occurs.

The system as described is capable of extension in several particulars. It is apparent that repetition and re-entrant features may be incorporated in the auxiliary FIFO portion of the apparatus, if so desired. For most purposes, the repetition feature appears to be sufficient for implementation in either the main or auxiliary FIFO. The re-entrant feature for the auxiliary FIFO is optional; if such function is present there is established a capability for nested loops of effective sequencing.

The architecture here described is extendable in the lateral sense by providing for a plurality of hierarchical auxiliary FIFOs in straightforward extensions of the apparatus described above. In this manner, the length of an effective instruction sequence to the device interface driver 66 may be further extended. Alternatively, nested looping is achievable by forming an inner loop through direction of the output of a first auxiliary FIFO to initialize a second auxiliary FIFO, thereby preserving the queue, then triggering an exchange of control to the second auxiliary FIFO. The latter then operates symmetrically to transfer its output, again both to the multiplexer 66 and to re-initialize the first auxiliary FIFO, again preserving the queue.

FIFO based instrument control and data acquisition systems have been implemented in apparatus where synchrony of discrete operational states as a principal requisite of desired instrument performance. Instruments which require data in the time domain are generally an example of a class of such apparatus. Other functional classes of equipment include those wherein it is desired to control the time dependence of some instrumental parameter, P(t) as well as, or in addition to the synchrony of P(0) and P($t_{final}$), e.g., the beginning and end points. The time dependence of magnetic gradients and RF pulse shapes employed for magnetic resonance imaging equipment is an example of both such desiderata.

## Claims

1. A method of processing a FIFO data list of variable length greater than a minimum number of words comprising:
    reading to a processor a first FIFO data list of no more than a fixed number of words characterised by
    detecting in said first FIFO data list a reference to a second FIFO list and interrupting such step of reading said first FIFO data list,
    reading said second FIFO data list of words to said processor,
    detecting in said second FIFO list an end of list word, and
    resuming reading said first FIFO data list to said processor.

2. A method as claimed in claim 1 wherein reading said first list comprises storing a main sequence of a first plurality of digital control words in a sequence of adjacent memory registers comprising initial and final memory registers and at least one intermediate memory register disposed therebetween, said registers (58) adapted for serial transfer of the contents thereof from said initial memory register through said intermediate memory register to said final memory register, each said digital control word comprising at least a first and second portion thereof, storing in addressable storage space (70) at least one auxiliary sequence comprising a second plurality of digital control words, each said digital control word of said auxiliary sequence comprising at least a first and second portion thereof, propagating said first sequence of digital control words through said sequence of said plurality of adjacent memory registers, said step of propagating occurring in incremental intervals of time, determining the duration of each said incremental interval of time from the content of said first portion of each said control word,

and wherein said detecting step comprises detecting a preselected one of said control words and in response thereto, propagating said auxiliary sequence of digital control words from said addressable storage space and inserting said auxiliary sequence of digital control words into an auxiliary sequence of adjacent memory registers (72), said auxiliary sequence and said main sequence of digital control words operating to form a composite sequence of digital control words,

the method further comprising controlling the state of a synchronous device in accord with said second portion of said digital control word of said composite sequence of digital control words.

3. A variable length FIFO register for furnishing a sequence of digital words to an output register (66), comprising:

first FIFO means (58) comprising an input stage, an output stage (59), and a plurality of intermediate communicating stages serially disposed between said input and output stage, said first FIFO means for receiving a first list of data words at said input stage and propagating said list through said plurality of intermediate communicating stages to said output stage, said output stage adapted to communicate with said output register,

characterised by

pre-FIFO decode means (54) for detecting a preselected token datum in said first list of data words prior to receipt of said preselected token data by said input stage,

memory means (70) for retaining a second list of data,

second FIFO means (72) comprising another plurality of communicating stages terminating in second FIFO output stage, said second FIFO means for receiving said second list of data from said memory means and propagating said second list of data to said second FIFO output stage, said second FIFO output stage being adapted to communicate with said output register (66),

second list fetch means (60A) responsive to said pre-FIFO decode means for retrieving said second data list from said memory means and initialising second FIFO means,

FIFO control transfer means (60B) for deactivating said first FIFO means and activating said second FIFO means in response to a preselected token datum then occupying said output stage and for deactivating said second FIFO means and reactivating said first FIFO means in response to another preselected token datum of said second list then occupying a selected stage of said second FIFO means.

4. Nuclear magnetic resonance apparatus comprising:

magnet means to establish a magnetic field distribution of preselected form over a selected volume region,

excitation means to excite nuclear magnetic resonance in at least a selected portion of said volume region,

signal processing means for detecting and recording nuclear magnetic resonance in said selected portion of said volume region,

a variable length FIFO register for furnishing a sequence of digital words representing operational states of said NMR apparatus as claimed in Claim 3,

control means for the control and correlation of said excitation, signal processing and magnet means in accord with an active operational stage derived from either said first FIFO means or said second FIFO means and

arbitration means for causing the next operational state of said NMR apparatus to be derived from either said first FIFO means or said second FIFO means in accord with said active operational state.

## Revendications

1. Méthode de traitement d'une liste de données FIFO de longueur variable, plus grande qu'un nombre minimum de mots, caractérisée en ce qu'elle comprend:

- la lecture sur un processeur d'une première liste de données FIFO ne dépassant pas un nombre fixé de mots,
- la détection dans ladite première liste de données FIFO d'une référence à une seconde liste FIFO et l'interruption d'une telle étape de lecture de ladite première liste de données FIFO,
- la lecture de ladite seconde liste de données FIFO de mots dudit processeur,
- la détection dans ladite seconde liste FIFO d'une fin d'une liste de mots, et
- la reprise de la lecture de ladite première liste de données FIFO dudit processeur.

2. Méthode selon la revendication 1, dans laquelle la lecture de ladite première liste comprend le stockage d'une séquence principale d'une première pluralité de mots de commande digitaux dans une séquence de registres de mémoire adjacents comprenant des registres de mémoire initial et final, et au moins un registre de mémoire intermédiaire disposé entre eux, lesdits registres (58) étant adaptés pour un transfert en série de leur contenu à partir dudit registre de mémoire initial, par ledit registre de mémoire intermédiaire, vers ledit registre de mémoire final, chacun desdits mots de commande digitaux comprenant au moins une première et une seconde portion d'entre eux, stockant dans un espace de stockage adressable (70) au moins une séquence auxiliaire comprenant une seconde pluralité de mots de commande digitaux, chacun desdits mots de commande digitaux de ladite séquence auxiliaire comprenant au moins une première et une seconde portion d'entre eux, propageant ladite première séquence de mots de commande digitaux par ladite séquence de ladite pluralité de registres de mémoire adjacents, ladite étape de propagation ayant lieu à des intervalles de temps incrémentés, déterminant la durée de chacun desdits intervalles de temps incrémenté par le contenu de ladite première portion de chacun desdits mots de commande, et dans laquelle ladite étape de détection comprend la détection de l'un desdits mots de commande présélectionné, et en réponse à ceci, la propagation de ladite séquence auxiliaire de mots de commande digitaux depuis ledit espace de stockage adressable et l'insertion de ladite séquence auxiliaire de mots de commande digitaux dans une séquence auxiliaire de registres de mémoire auxiliaires (72), ladite séquence auxiliaire et ladite séquence principale de mots de commande digitaux fonctionnant pour former une séquence composite de mots de commande digitaux, la méthode comprenant ensuite la commande de l'état d'un dispositif synchronisé avec ladite seconde portion dudit mot de commande digital de ladite séquence composite de mots de commande digitaux.

3. Registre FIFO de longueur variable pour fournir une séquence de mots digitaux à un registre de sortie (66), comprenant
   - des premiers moyens FIFO (58) comprenant un étage d'entrée, un étage de sortie (59) et une pluralité d'étages intermédiaires en communication, disposés en série entre lesdits étages d'entrée et de sortie, lesdits premiers moyens FIFO pour recevoir une première liste de mots de données sur ledit étage d'entrée et propageant ladite liste à travers ladite pluralité d'étages intermédiaires en communication vers ledit étage de sortie, ledit étage de sortie étant adapté pour communiquer avec ledit registre de sortie, caractérisé par
   - des moyens de décodage (54) avant le FIFO pour détecter une donnée en jeton présélectionnée dans ladite première liste de mots de données avant la réception de ladite donnée en jeton présélectionnée par ledit étage d'entrée,
   - des moyens de mémoire (70) pour retenir une seconde liste de données,
   - des seconds moyens FIFO (72) comprenant une autre pluralité d'étages en communication se terminant sur un second étage de sortie FIFO, lesdits seconds moyens FIFO pour recevoir ladite seconde liste de données desdits moyens de mémoire et propageant ladite seconde liste de donnée vers ledit second étage de sortie FIFO, ledit second étage de sortie FIFO étant adapté pour communiquer avec ledit registre de sortie (66),
   - des seconds moyens d'amenée de liste (60A) répondant auxdits moyens de décodage avant le FIFO pour récupérer ladite seconde liste de données desdits moyens de mémoire et initialiser les seconds moyens FIFO,
   - des moyens de transfert de commande FIFO (60B) pour désactiver lesdits premiers moyens FIFO et activer lesdits seconds moyens FIFO en réponse à une donnée en jeton présélectionnée puis occuper ledit étage de sortie, et pour désactiver lesdits seconds moyens FIFO et réactiver lesdits premiers moyens FIFO en réponse à une autre donnée en jeton présélectionnée de ladite seconde liste, puis occuper un étage sélectionné desdits seconds moyens FIFO.

4. Appareil de résonance magnétique nucléaire comprenant
   - des moyens magnétiques pour établir une distribution de champ magnétique d'une forme présélectionnée sur une région volumique sélectionnée,
   - des moyens d'excitation pour exciter la résonance magnétique nucléaire dans au moins une portion sélectionnée de ladite région volumique,
   - des moyens de traitement de signaux pour détecter et enregistrer la résonance magnétique nucléaire dans ladite portion sélectionnée de ladite région volumique,

- un registre FIFO de longueur variable pour fournir une séquence de mots digitaux représentant les états de fonctionnement dudit appareil RMN, selon la revendication 3,

- des moyens de commande pour la commande et la corrélation de ladite excitation, des moyens magnétiques et de traitement de signaux en accord avec un étage opérationnel actif provenant soit desdits premiers moyens FIFO ou desdits seconds moyens FIFO, et

- des moyens d'arbitrage pour provoquer la prochaine étape opérationnelle dudit appareil RMN, provenant soit desdits premiers moyens FIFO, soit desdits seconds moyens FIFO, en accord avec ledit état opérationnel actif.

## Ansprüche

1. Verfahren zum Verarbeiten einer FIFO-Datenliste von variabler Länge grösser als eine Minimalzahl von Wörtern, umfassend

   das Lesen einer ersten FIFO-Datenliste von nicht mehr als einer bestimmten Anzahl von Wörtern in einen Prozessor, gekennzeichnet durch

   das Ermitteln einer Referenz in der genannten ersten FIFO-Datenliste an eine zweite FIFO-Liste und Unterbrechen eines solchen Schrittes des Lesens der genannten ersten FIFO-Datenliste,

   das Lesen der genannten zweiten FIFO-Datenliste von Wörtern in den genannten Prozessor,

   das Ermitteln eines Endes einer Wörterliste in der genannten zweiten FIFO-Liste und

   die Wiederaufnahme des Lesens der genannten ersten FIFO-Datenliste in den genannten Prozessor.

2. Verfahren nach Patentanspruch 1, wobei das Lesen der ersten genannten Liste das Speichern einer Hauptfolge einer ersten Mehrzahl von digitalen Steuerwörtern in einer Folge von angrenzenden Speicherregistern mit Anfangs- und Endspeicherregistern und mindestens einem dazwischen angeordneten Zwischenspeicherregister umfasst, die Register (58) für die serielle Uebertragung ihres Inhaltes vom genannten Anfangsspeicherregister durch das genannte Zwischenspeicherregister zum genannten Endspeicherregister angepasst sind, wobei jedes genannte digitale Steuerwort mindestens einen ersten und zweiten Teil davon enthält, im adressierbaren Speicherraum (70) mindestens eine Hilfsfolge mit einer zweiten Mehrzahl von digitalen Steuerwörtern gespeichert wird, wobei jedes der genannten digitalen Steuerwörter der genannten Hilfsfolge mindestens einen ersten und zweiten Teil davon enthält, Uebertragung der ersten Folge von digitalen Steuerwörtern durch die genannte Folge der genannten Mehrzahl von angrenzenden Speicherregistern, wobei der genannte Schritt der Uebertragung in inkrementalen Zeitintervallen erfolgt, Bestimmung der Dauer jedes der genannten inkrementalen Zeitintervalle aus dem Inhalt des genannten ersten Teiles jedes der genannten Steuerwörter, wobei der genannte Ermittlungsschritt das Ermitteln eines vorgewählten der genannten Steuerwörter umfasst und in Antwort darauf die genannte Hilfsfolge von digitalen Steuerwörtern vom genannten adressierbaren Speicher übertragen wird und die genannte Hilfsfolge von digitalen Steuerwörtern in eine Hilfsfolge von angrenzenden Speicherregistern (72) eingefügt wird, wobei die genannte Hilfsfolge und die genannte Hauptfolge von digitalen Steuerwörtern derart wirken, dass sie eine zusammengesetzte Folge von digitalen Steuerwörtern bilden, das Verfahren weiter die Steuerung des Zustandes einer synchronen Vorrichtung in Einklang mit dem genannten zweiten Teil des genannten digitalen Steuerwortes der genannten zusammengesetzten Folge von digitalen Steuerwörtern umfasst.

3. FIFO-Register mit einer variablen Länge zum Liefern einer Folge von digitalen Wörtern zu einem Ausgangsregister (66), umfassend

   erste FIFO-Mittel (58), umfassend eine Eingangsstufe, eine Ausgangsstufe (59) und eine Mehrzahl von kommunizierenden Zwischenstufen, welche seriell zwischen den genannten Eingangs- und Ausgangsstufen angeordnet sind, die genannten ersten FIFO-Mittel zum Empfang einer ersten Liste von Datenwörtern bei der genannten Eingangsstufe und Uebertragung der genannten Liste durch die genannte Mehrzahl von kommunizierenden Zwischenstufen zur genannten Ausgangsstufe, die genannte Ausgangsstufe angepasst ist, um mit dem genannten Ausgangsregister zu kommunizieren, gekennzeichnet durch

   Vor-FIFO-Dekodiermittel (54) zur Ermittlung einer vorgewählten gegebenen Grösse einer Berechtigungsmarke in der genannten ersten Datenwörterliste vor dem Empfang der genannten vorgewählten gegebenen Grösse der Berechtigungsmarke durch die genannte Eingangsstufe,

Speichermittel (70) zum Zurückhalten einer zweiten Datenliste,

zweite FIFO-Mittel (72), welche eine andere Mehrzahl von kommunizierende Stufen umfassen, welche in einer zweiten FIFO-Ausgangsstufe enden, die genannten zweiten FIFO-Mittel zum Empfang der genannten zweiten Datenliste von dem genannten Speichermittel und Uebertragung der genannten zweiten Datenliste zur zweiten FIFO-Ausgangsstufe, die genannte zweite FIFO-Ausgangsstufe angepasst ist, um mit dem genannten Ausgangsregister (66) zu kommunizieren,

zweite Mittel (60A) zum Heranholen von Listen, welche auf die genannten Vor-FIFO-Dekodiermittel ansprechen zum Wiederauffinden der genannten zweiten Datenliste von den genannten Speichermitteln und zum Initialisieren der zweiten FIFO-Mittel,

FIFO-Steuerübertragungsmittel (60B) zur Inaktivierung der genannten ersten FIFO-Mittel und Aktivieren der genannten zweiten FIFO-Mittel in Antwort auf eine vorgewählte gegebenen Grösse einer Berechtigungsmarke und dann die genannte Ausgangsstufe besetzt wird und zur Inaktivierung der genannten zweiten FIFO-Mittel und Reaktivierung der genannten ersten FIFO-Mittel in Antwort auf eine andere vorgewählte gegebene Grösse einer Berechtigungsmarke der genannten zweiten Liste und dann Besetzen einer ausgewählten Stufe der genannten zweiten FIFO-Mittel.

4.  Vorrichtung für die kernmagnetische Resonanz, umfassend:

magnetische Mittel zur Bildung einer magnetischen Feldverteilung einer vorgewählten Form über einen ausgewählten Volumenbereich,

Anregungsmittel zum Anregen kernmagnetischer Resonanz in mindestens einem ausgewählten Teil des genannten Volumenbereichs,

Signalverarbeitungsmittel zur Ermittlung und Aufzeichnung kernmagnetischer Resonanz im genannten ausgewählten Teil des genannten Volumenbereiches,

ein FIFO-Register variabler Länge zur Zuführung einer Folge digitaler Wörter, welche Funktionszustände des genannten NMR-Apparates gemäss Patentanspruch 3 darstellen,

Steuermittel zur Steuerung und Korrelation der genannten Anregung, Signalverarbeitungs- und Magnetmittel in Uebereinstimmung mit einer aktiven Funktionsstrufe, abgeleitet entweder von den genannten ersten FIFO-Mitteln oder den genannten zweiten FIFO-Mitteln und

arbitrationale Mittel zur Verursachung des nächsten Funktionszustandes des genannten NMR-Apparates, um entweder von den genannten ersten FIFO-Mitteln oder den genannten zweiten FIFO-Mitteln abgeleitet zu werden in Uebereinstimmung mit dem genannten aktiven Funktionszustand.

FIG.1

HOST COMPUTER

4

ACQUISITION PROCESSOR

50

PULSE SEQUENCE & COMMAND

51

6

NMR SPECTROMETER

31  84  82  1 0

FIG.3A | | PERSISTENCE CODE | OPERATIONAL STATE | 0 |

MAIN FIFO SEQUENCE WORD

31  86  1 0

FIG.3B | | ROM ADDRESS OF SUBSEQUENCE | 1 |

MAIN FIFO SUBSEQUENCE CALL

31  89  88  1 0

FIG.3C | | PERSISTENCE CODE | OPERATING STATE | 0 |

AUXILIARY FIFO SUBSEQUENCE WORD

31  1 0

FIG.3D | UNUSED | 1 |

AUXILIARY FIFO RETURN

90

9

EP 0 188 052 B1

## FIG.2

TO SPECTROMETER

## FIG.4